(19) Europäisches Patentamt
European Patent Office
Office européen des brevets

(11) **EP 2 691 785 B1**

(12) **FASCICULE DE BREVET EUROPEEN**

(45) Date de publication et mention de la délivrance du brevet:
**05.12.2018 Bulletin 2018/49**

(21) Numéro de dépôt: **12710927.0**

(22) Date de dépôt: **22.03.2012**

(51) Int Cl.:
***G01R 31/08*** *(2006.01)*

(86) Numéro de dépôt international:
**PCT/EP2012/055065**

(87) Numéro de publication internationale:
**WO 2012/130710 (04.10.2012 Gazette 2012/40)**

(54) **SYSTEME ET PROCEDE PERMETTANT DE DETECTER UNE DETERIORATION OU UNE COUPURE DANS UN CABLE TRANSPORTANT DES SIGNAUX**

SYSTEM UND VERFAHREN ZUR ERKENNUNG VON VERSCHLEISS ODER UNTERBRECHUNG EINES KABELS ZUR SIGNALÜBERMITTLUNG

SYSTEM AND METHOD FOR DETECTING DETERIORATION OR INTERRUPTION IN A CABLE CONDUCTING SIGNALS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.03.2011 FR 1100962**

(43) Date de publication de la demande:
**05.02.2014 Bulletin 2014/06**

(73) Titulaire: **THALES**
**92400 Courbevoie (FR)**

(72) Inventeur: **CHARLOT, Bernard**
**F-31000 Toulouse (FR)**

(74) Mandataire: **Dudouit, Isabelle**
**Marks & Clerk France**
**Conseils en Propriété Industrielle**
**Immeuble " Visium "**
**22, avenue Aristide Briand**
**94117 Arcueil Cedex (FR)**

(56) Documents cités:
**EP-A2- 1 016 869       US-A1- 2004 039 976**
**US-A1- 2006 012 374**

## Description

L'invention concerne un système et un procédé permettant de détecter une zone dans laquelle s'est produit une détérioration, une coupure ou tout défaut physique empêchant la bonne transmission de signaux électriques, et l'instant d'apparition du problème. Elle est utilisée, par exemple, pour des câbles de grande longueur, de l'ordre de quelques kms.

Elle s'applique pour des câbles électriques transportant des signaux électriques, pour des fibres optiques transportant des signaux optiques, par exemple.

Elle peut être utilisée dans le domaine des réseaux électriques, ferroviaire, télécommunications, ceci pour des réseaux terrestres ou encore des réseaux mis en oeuvre sur des navires.

Sur les grands réseaux électrifiés, la localisation rapide de la position où un câble a été coupé ou détérioré est un enjeu majeur:

- dans le cas d'une coupure pour vol du câble, une intervention rapide peut permettre d'éviter le vol et d'appréhender les auteurs,
- dans le cas d'une coupure ou d'une détérioration fortuite par accident ou par malveillance, la connaissance immédiate de l'endroit ou de la zone de coupure ou de dégradation permet d'optimiser l'intervention des équipes de maintenance et de minimiser ainsi la durée de l'incident et donc l'impact sur le service rendu.

Si la détection de la coupure est aisée car elle se traduit par une absence de transmission de signal, sa localisation est difficile, en particulier si le câble n'est pas accessible visuellement. Dans tous les cas, la recherche de la coupure ou de la détérioration par inspection visuelle est longue.

Une solution industrielle existante est d'utiliser un réflectomètre électrique R à impulsions I.

Ce dispositif est basé sur la réflexion d'une impulsion électrique sur tout front de variation d'impédance du câble, en particulier une coupure. Les différents inconvénients de cette technologie sont donnés ci-après :

- par nature, il ne peut fonctionner en parallèle de la transmission d'énergie dans le câble sauf cas particulier. Le câble doit donc être parfaitement déconnecté. Ce n'est donc pas un moyen de surveillance, mais uniquement un moyen de préparation de la réparation;
- la longueur du câble mesurée est limitée par le principe physique utilisé, les valeurs courantes sont de quelques milliers de mètres au maximum; et
- la précision de la localisation diminue avec la longueur du câble; typiquement 0,2% de la longueur.

L'art antérieur décrit aussi une approche qui utilise des signaux issus de satellites GPS. Cette technique utilise le fait que lorsqu'un incident intervient sur un réseau, l'arc qui naît du défaut est immédiatement suivi par deux impulsions haute tension qui se propagent de part et d'autre de ce défaut. En équipant chaque extrémité du câble d'un détecteur de passage d'ondes de choc et d'une antenne GPS locale, l'électronique commune de traitement du signal est alors synchronisée avec l'horloge GPS. Chaque station locale de traitement est alors reliée, soit par modem, soit par fibre optique à une station de traitement principale qui effectue les calculs adéquats. Cette méthode de pré localisation s'applique telle quelle aux réseaux sans dérivation. Cette technologie utilise donc les signaux générés par la rupture d'un câble.

L'enseignement technique du document US 2006/012374 décrit un système dans lequel un défaut dans un système de puissance engendre des ondes qui se propagent à travers le système loin du point où le défaut a été généré à des vitesses proches de la vitesse de la lumière. Les ondes se réfléchissent en des points où l'impédance du système change

L'enseignement technique du document US 2004/039976 est de modifier le signal original de données en utilisant des techniques DSSS pour étaler le signal d'origine et rendre son niveau faible ou comparable à du bruit. Ce procédé permet d'effecteur le test sur les fils qui sont utilisés. Le procédé utilise donc un signal extérieur au système

La recrudescence de vols de câble représentant un coût très élevé, des millions d'euros de pertes, les opérateurs ou industriels concernés sont toujours à la recherche de méthodes de détection rapides, efficaces. De même, la détérioration des équipements intentionnelle ou non intentionnelle engendre à des dysfonctionnements et donc des coûts de fonctionnement des systèmes plus élevés.

L'idée mise en oeuvre dans la présente demande de brevet repose sur une nouvelle approche permettant de localiser instantanément la position de la coupure ou de la détérioration d'un câble électrique éventuellement très long, plusieurs dizaines de kilomètres, par exemple. Ceci peut aussi s'appliquer à tout câble conduisant des signaux physiques, tels que des fibres optiques, etc.

La solution est notamment basée sur l'application des techniques de localisation spatiale disposant d'une synchronisation entre deux points ou noeuds d'un réseau.

L'invention concerne un système pour détecter des détériorations ou des coupures C au niveau d'un câble destiné à transmettre des signaux, entre au moins un premier dispositif A et au moins un deuxième dispositif B, ledit système comprenant le premier dispositif A et le deuxième dispositif B, et un moyen adapté à connaître la vitesse de propagation du signal dans ledit câble, caractérisé en ce que :

- ledit premier dispositif A étant disposé à une première extrémité du câble et comprenant au moins un dispositif émetteur/récepteur, des moyens de synchronisation, un moyen de communication entre le premier dispositif A et le deuxième dispositif B quelque soit l'état du câble, des moyens de calcul de non réception du signal reliés au dispositif émetteur/récepteur, le dispositif émetteur est adapté à émettre un signal $S_A$ de A vers B, et le dispositif récepteur est adapté à mesurer un instant de non réception d'un signal,
- ledit deuxième dispositif B étant disposé à une deuxième extrémité du câble, ledit deuxième dispositif B comprenant au moins les éléments suivants, un dispositif émetteur/récepteur, des moyens de synchronisation et d'émission simulatnée du signal $S_A$ et du signal $S_B$, des moyens de communication entre A et B quelques soit l'état du câble, des moyens de calcul de non réception du signal reliés au dispositif émetteur/récepteur, le dispositif émetteur est adapté à émettre un signal $S_B$ de B vers A, et le dispositif récepteur est adapté à mesurer un instant de non réception du signal,
- les moyens de communication des mesures des instants de non réception des signaux effectuées au niveau des récepteurs, sont adaptés à transférer les mesures des instants de non réception du signal $S_B$ au niveau du premier dispositif A et de non réception du signal $S_A$ au niveau du deuxième dispositif B, auxdits moyens de calcul de non réception d'un signal, lesdits moyens de calcul étant adaptés à déterminer l'instant $t_C$ et la localisation $X_C$ du défaut ou de la coupure au niveau du câble à partir des mesures de l'abscisse $X_A$ de A et de l'abscisse $X_B$ de B, de la vitesse de propagation V connue entre le point A et le point B, de l'instant $tr_B$ de disparition du sigjal mesuré par le récepteur A sur le signal $S_B$.

Les moyens de calcul de non réception du signal sont, par exemple, adaptés à exécuter au moins les étapes suivantes:

soit $X_A$ l'abscisse curviligne de A compté sur le câble, $X_B$ est l'abscisse curviligne de B considérée sur le câble, en considérant un sens croissant d'abscisse de B vers A,
V étant la vitesse de propagation moyenne d'un signal dans le câble entre A et B, considérée constante ou sensiblement constante
soit $X_C$ l'abscisse curviligne du point de détérioration ou de coupure C du câble et $t_C$ l'instant de coupure
soit $tr_B$ l'instant de disparition du signal mesuré par le récepteur B sur le signal $S_A$ et $tr_A$ l'instant de disparition du signal mesuré par le récepteur A sur le signal $S_B$
ce qui donne la localisation $X_C$ de la coupure C au niveau du câble 1

$$X_C = (X_A + X_B)/2 + V.(tr_B - tr_A)$$

et l'instant de coupure $t_C$

$$t_C = (tr_A + tr_B)/2 + (X_B - X_A)/2V$$

Les signaux $S_A$, $S_B$ émis par A et par B sont des signaux CDMA.
Le câble est, par exemple, un câble en cuivre.
Selon une autre variante de réalisation, le câble est une fibre optique et les signaux émis pour détecter la détérioration ou la coupure des signaux optiques.
Les moyens de communication entre le premier dispositif A et le deuxième dispositif B sont, par exemple, composés d'un téléphone sans fil ou de tout autre moyen de communication numérique, par exemple, une fois que le câble est détérioré afin de ramener l'information au niveau des dispositifs.
Les moyens de synchronisation comportent par exemple un récepteur GPS.
L'invention concerne aussi un procédé permettant de détecter des détériorations ou des coupures C au niveau d'un câble destiné à transmettre des signaux, le procédé étant mis en oeuvre dans le système selon la revendication 1, caractérisé en ce qu'il comporte au moins les étapes suivantes :

- émettre simultanément au moins un premier signal $S_A$ d'un premier dispositif A vers un deuxième dispositif B et au moins un deuxième signal $S_B$ du deuxième dispositif B vers le premier dispositif A, l'émission desdits signaux se faisant de manière synchronisée,

- détecter l'instant $tr_B$ auquel il y a absence de réception du signal $S_A$ au niveau du récepteur de B et l'instant $tr_A$ d'absence du signal $S_B$, au niveau du récepteur de A,
- déterminer à partir de $tr_A$ l'instant de disparition du signal mesuré par le récepteur A, et de $tr_B$ l'instant de disparition du signal mesuré par le récepteur B, l'endroit $X_C$ et le moment $t_C$ de la coupure ou de la détérioration sur le câble.

La mesure de disparition de l'instant $tr_A$ de disparition du signal mesuré par le récepteur A, et de $tr_B$ l'instant de disparition du signal mesuré par le récepteur B, se fait, par exemple, en utilisant une valeur de niveau seuil S en dessous-duquel les signaux ne sont plus détectables.

Le procédé comporte, par exemple, au moins les étapes suivantes :

soit $X_A$ l'abscisse curviligne de A compté sur le câble, $X_B$ est l'abscisse curviligne de B considérée sur le câble, en considérant un sens croissant d'abscisse de B vers A,

V étant la vitesse de propagation moyenne d'un signal dans le câble entre A et B, considérée constante ou sensiblement constante

soit $X_C$ l'abscisse curviligne du point de détérioration ou de coupure C du câble et $t_C$ l'instant de coupure

soit $tr_B$ l'instant de disparition du signal mesuré par le récepteur B sur le signal $S_A$ et $tr_A$ l'instant de disparition du signal mesuré par le récepteur A sur le signal $S_B$

ce qui donne la localisation $X_C$ de la coupure C au niveau du câble

$$X_C = (X_A + X_B)/2 + V.(tr_B - tr_A)$$

et l'instant de coupure $t_C$

$$t_C = (tr_A + tr_B)/2 + (X_B - X_A)/2V$$

On peut utiliser des signaux CDMA et détecter les derniers symboles reçus respectivement par au moins le premier dispositif A et au moins le deuxième dispositif B pour déterminer la zone de la coupure ou de la détérioration du câble.

Le système et le procédé selon l'invention peuvent être utilisés pour détecter des coupures ou des détériorations au niveau de câble en cuivre.

D'autres caractéristiques et avantages de la présente invention apparaîtront mieux à la lecture de la description qui suit d'un ou plusieurs exemples de réalisation annexée des figures qui représentent:

- La figure 1, un exemple de technologie de l'art antérieur utilisant un réflectomètre,
- La figure 2, un schéma de principe du système de détection selon l'invention,
- La figure 3, un exemple d'implémentation du système,
- La figure 4, une illustration pour le principe de mesure.

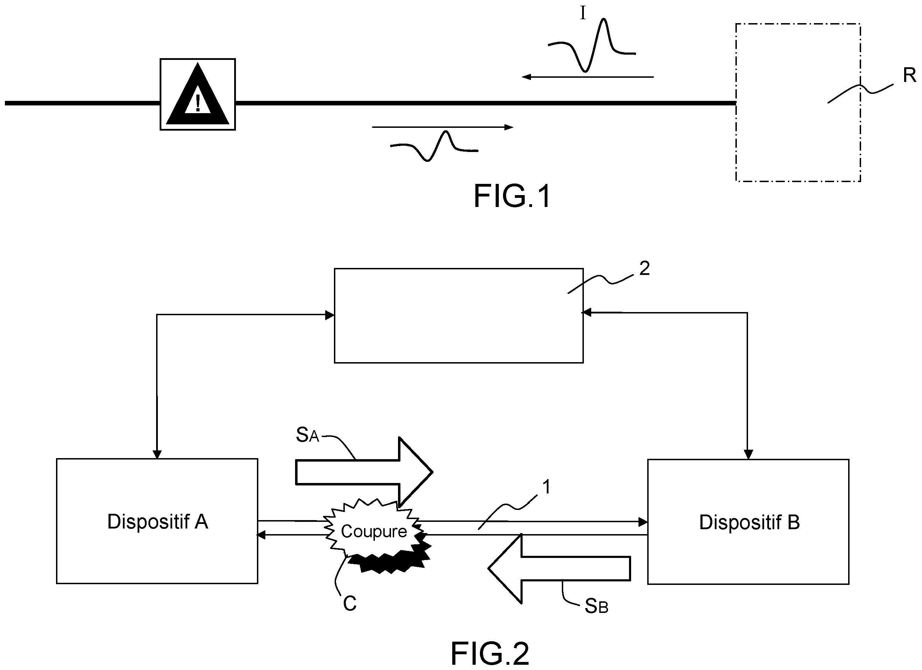

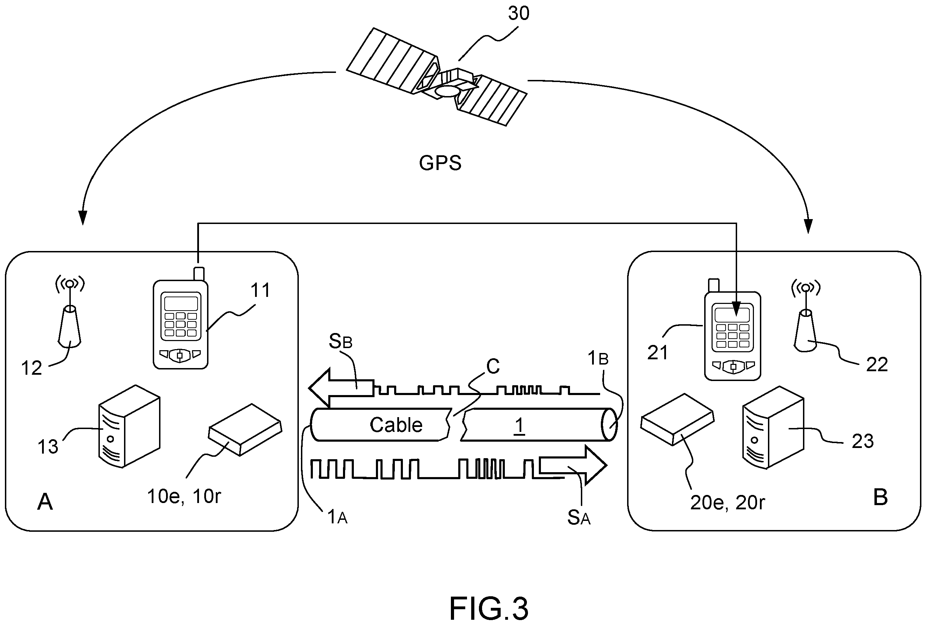

La figure 2 illustre le principe mis en oeuvre par le système et le procédé selon l'invention, dans le cas d'un câble 1 transportant des signaux électriques. Un moyen de communication 2 (11, 21 figure 3) permet le passage des informations entre les deux dispositifs A et B quelque soit l'état du câble, en particulier lorsqu'il y a une coupure ou une détérioration, comme il sera détaillé à la figure 3, dans le cadre d'un exemple donné à titre illustratif et nullement limitatif. Le dispositif A émet un signal $S_A$ vers le dispositif B, le dispositif B émet simultanément un signal $S_B$ vers le dispositif A, l'émission des signaux $S_A$, $S_B$ est synchronisée par des moyens de synchronisation adaptés à avoir une émission synchronisée du signal $S_A$ et du signal $S_B$, détaillés ci-après. La coupure éventuelle est représentée par le point C.

Dans certains cas, le moyen de communication peut aussi avoir pour fonction de synchroniser les émissions de signaux entre les dispositifs.

Sans sortir du cadre de l'invention, le système de synchronisation est, par exemple, basé sur une autre constellation GNSS que le GPS, GALILEO, GLONAS, ou d'autres constellations ou plusieurs constellations.

Il est aussi possible d'utiliser un moyen de synchronisation réseau connu de l'Homme du métier, comme le standard Network Time Protocol (RFC 958). Dans ce cas, les dispositifs A et B sont reliés à un réseau fournissant au moins un serveur NTP. Ceci permet notamment d'obtenir des précisions décamétriques.

Un autre mode de réalisation des moyens de synchronisation consiste à utiliser deux horloges de haute précision, par exemple l'horloge atomique rubidium ou césium qui présente une dérive faible dans le temps. Les horloges sont synchronisées avant leur utilisation et, le cas échéant, à des intervalles réguliers dépendant de leur dérive propre et de la précision requise. Le réglage initial est effectué par détermination d'un écart de temps commun au temps GPS, La précision atteinte peut être très importante (typiquement décimétrique) selon le choix des horloges et la période de resynchronisation choisie.

En résumé, pour mettre en oeuvre le système et le procédé selon l'invention qui seront détaillés ci-après, il faut au moins 2 mesures pour calculer l'instant et la position de coupure C sur le câble 1 et l'utilisation d'un moyen de communication d'informations entre A et B après coupure ou disparition du signal reçu au niveau de A et/ou de B. La mise en oeuvre du procédé selon l'invention nécessite en effet d'avoir les deux mesures regroupées dans un calculateur pour permettre de calculer une solution.

La figure 3 représente un exemple d'implémentation du système et du procédé selon l'invention pour la détection d'un défaut ou d'une coupure au niveau d'un câble électrique.

Le système permettant de détecter l'instant de non réception du signal au niveau d'un émetteur, de déterminer l'instant et la zone de coupure dans cet exemple de réalisation comporte un câble 1 comprenant à une première de ses extrémités $1_A$ un dispositif A et à la deuxième extrémité $1_B$ un dispositif B.

Le dispositif A comprend par exemple :

- un modem émetteur/récepteur 10e, 10r ayant notamment pour fonction d'émettre un signal $S_A$ de A vers B sur le câble 1 où la coupure peut se produire et de recevoir les mesures des instants de non réception du signal $S_B$ dans le cas où les signaux ne parviennent plus à circuler dans le câble,
- un moyen de communication 11 entre les dispositifs A et B qui permet le transfert des données lorsque la transmission des informations par câble n'est plus possible,
- un moyen de synchronisation 12 des émissions des signaux entre A et B, et
- un calculateur 13 relié au récepteur 10r afin de calculer l'instant et la zone de coupure en mettant en oeuvre le procédé selon l'invention qui va être explicité ci-après.

Le récepteur 10r est adapté pour capter et mémoriser l'instant de non réception du signal $S_B$: émis par le dispositif B vers le dispositif A.

Le dispositif B comprend, par exemple,

- un modem émetteur/récepteur 20e, 20r ayant notamment pour fonction d'émettre un signal $S_B$ de B vers A sur le câble 1 où la coupure peut se produire et de recevoir les mesures des instants de non réception du signal $S_A$ dans le cas où les signaux ne parviennent plus à circuler dans le câble,
- un moyen de communication 21 entre B et A qui permet le transfert des données lorsque la transmission par câble n'est plus possible,
- un moyen de synchronisation 22 permettant l'émission simultanée du signal $S_B$ et du signal $S_A$,
- un calculateur 23 relié au récepteur 20r afin de calculer l'instant et la zone de coupure en mettant en oeuvre le procédé selon l'invention qui va être explicité ci-après.

Le modem récepteur 20r permet de capter l'instant de non réception du signal $S_A$ qu'aurait recevoir le dispositif B s'il n'y avait pas de coupure ou de détérioration sur le câble 1.

L'idée mise en oeuvre par le procédé et le système selon l'invention est de surveiller les instants où ces signaux $S_A$ $S_B$ ne seront plus reçus par la partie réception du modem au niveau des récepteurs 10r, 20r.

La synchronisation des émissions entre le premier dispositif A et le deuxième dispositif B peut être assurée, par exemple, par les deux moyens de synchronisation 12, 22 qui utilisent des signaux émis par la constellation GPS 30, afin de déterminer un écart temps commun au temps GPS (global positioning system). Les moyens de synchronisation sont adaptés pour effectuer une synchronisation simultanée des signaux $S_A$ $S_B$ entre le premier dispositif A et le second dispositif B.

Les moyens de communication des informations ou des signaux une fois que le câble est détérioré sont par exemple des moyens de communication numérique, un téléphone cellulaire, ou tout autre réseau de communication.

Afin de mettre en oeuvre le procédé selon l'invention, la valeur de la vitesse de circulation des signaux doit être connue. On prendra comme valeur de vitesse une valeur de vitesse moyenne afin de s'affranchir d'éventuels défauts d'homogénéité de la structure du câble.

Pour cela, connaissant les caractéristiques géométriques du câble, sa longueur, etc. on détermine lors d'une phase d'initialisation le temps de parcours d'un signal émis du dispositif A vers le dispositif B ou réciproquement, temps tp, puis on divise la longueur du câble Lc par ce temps de parcours pour obtenir la vitesse moyenne appelée V.

Les caractéristiques du câble peuvent être connues à l'avance, ou encore déterminées par des dispositifs appropriés connus de l'Homme du métier.

Dans l'exemple qui va être donné pour illustrer le procédé selon l'invention, il y a une dimension à mesurer correspondant à l'abscisse curviligne et une ambigüité de temps (2 équipements émetteur) à chaque extrémité 1A, 1B du câble 1.

Les caractéristiques fréquentielles des signaux émis seront, par exemple, choisies en fonction de la nature du câble examiné.

La mise en oeuvre du procédé selon l'invention décrite en relation avec la figure 3 au sein de ce dispositif est, par exemple, la suivante:

a) l'émetteur 10e du dispositif A émet un premier signal $S_A$ de A vers le dispositif B et simultanément, l'émetteur 20e de B émet un signal $S_B$ de B vers le dispositif A,

b) les émissions des signaux $S_A$ et $S_B$ sont synchronisées par les moyens de synchronisation 12, 22 (A et B sont munis d'émetteurs/récepteurs de signal finement synchronisés entre eux par le moyen ad hoc précité).

c) dans le cas d'une détérioration C du câble 1 suffisante pour empêcher la transmission des signaux ou d'une coupure, les dispositifs A et B ne recevront pas de signaux. C'est cette information de non réception du signal qui va être utilisée dans le procédé pour déterminer l'endroit de coupure ou de détérioration et l'instant d'apparition de ce problème sur la base suivante :

a) en considérant la partie de câble entre A et B, et en prenant X l'abscisse curviligne mesurée sur ce câble, comptée positivement de B vers A, abscisse croissante de B vers A par exemple ;

b) $X_A$ est l'abscisse curviligne de A, $X_B$ est l'abscisse curviligne de B;

c) soit V la vitesse de propagation moyenne du signal dans le câble entre A et B, considérée constante connue à l'avance;

d) soit C un point où le câble est coupé. Soit XC l'abscisse curviligne de C et $t_C$ l'instant de coupure ou de détérioration du câble. $X_C$ et $t_C$ sont les inconnues à déterminer ;

Le procédé se propose de mesurer l'instant de disparition des signaux $S_A$, $S_B$ lors de la coupure ou de la détérioration du câble:

e) $tr_B$ est l'instant de disparition du signal mesuré par le récepteur B sur le signal $S_A$.

f) $tr_A$ est l'instant de disparition du signal mesuré par le récepteur A sur le signal $S_B$.

Les instants $tr_B$, $tr_A$ de disparition des signaux peuvent être déterminés en utilisant une valeur seuil S à partir de laquelle le signal ne peut plus être détecté.

On a alors les deux équations de propagation suivantes données dans le cas d'une abscisse croissante de B vers A :

$$(1) \text{ pour le signal } S_A : X_B = X_C - V.(tr_B - t_C)$$

$$(2) \text{ pour le signal } S_B : X_A = X_C + V.(tr_A - t_C)$$

ce qui donne la localisation $X_C$ de la coupure C au niveau du câble 1

$$(3) \qquad X_A + X_B = 2X_C + V (tr_A - tr_B)$$

soit

$$(3') \qquad X_C = (X_A + X_B)/2 + V.(tr_B - tr_A)$$

et l'instant de coupure $t_C$

$$(4) \qquad X_B - X_A = -V(tr_B - T_C) - V(tr_A - t_C)$$

soit

$$(4') \qquad (X_B - X_A)/V = -tr_A - tr_B + 2t_C$$

soit

$$(4'') \qquad t_C = (tr_A + tr_B)/2 + (X_B - X_A)/2V$$

En prenant comme convention, une abscisse croissante à partir de A et en allant vers B, il suffit alors de considérer la vitesse V'=-V.

Le moyen de communication peut aussi être une transmission radio UHF, VHF, un lien téléphonique, un autre câble reliant les deux points.

La synchronisation entre les dispositifs A et B peut être assurée par un récepteur GPS ou Galileo présent dans chaque dispositif, un dispositif de synchronisation de réseaux connu de l'Homme du métier, empruntant éventuellement le câble lui-même; dans ce cas, la synchronisation devient inutile après la coupure.

Les signaux utilisés pour détecter la coupure ou l'endroit et l'instant de détérioration du câble peuvent être soit le signal transmis normalement par le câble, dont c'est la fonction première, ou des signaux ad hoc générés par les dispositifs émetteurs de A et de B et multiplexés par le câble. Dans ce dernier cas, l'utilisation d'une transmission utilisant un codage basé sur l'accès multiple par répartition en code de type CDMA (abréviation anglo-saxonne de Code Divisional Multiple Access), par exemple est particulièrement adaptée pour éviter l'interférence des signaux entre eux et le cas échéant avec le signal de base dont le câble peut être porteur.

Le jeu de mesures peut comporter soit la mesure précise de l'instant de perte de réception du signal dans chaque dispositif après la coupure ou bien la détermination du dernier symbole reçu dans le cadre d'une transmission CDMA.

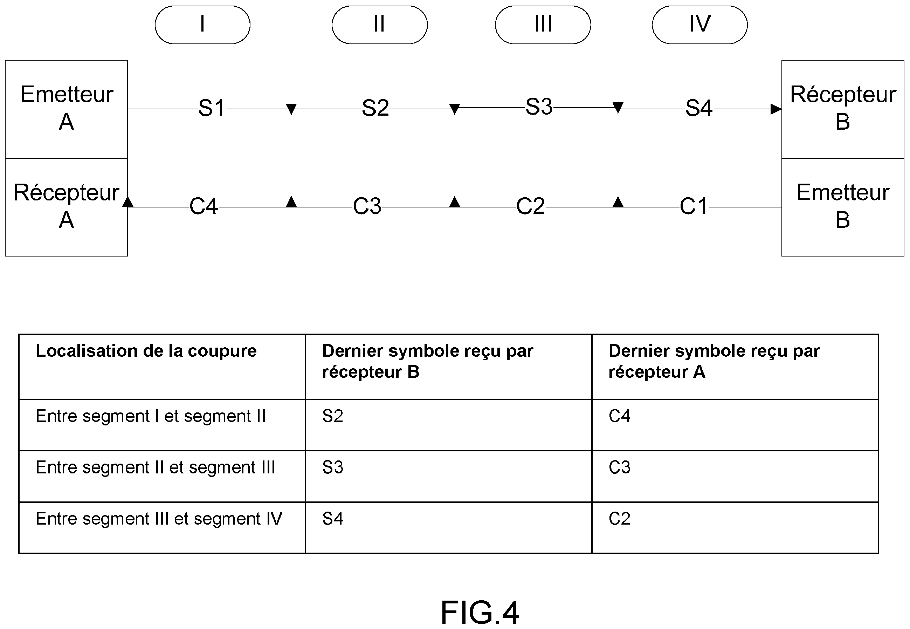

La figure 4 illustre un exemple de mise en oeuvre du procédé selon l'invention dans le cas d'une transmission de type CDMA. Le tableau regroupe en fonction du symbole reçu par le récepteur de B et par le symbole reçu par le récepteur A, la localisation de la coupure.

Par exemple, sur la figure la longueur du câble est divisée en 4 segments nommés I, II, III, IV. A émet un signal constitué de créneaux temporels S1, S2, S3, S4 en direction de B et B émet un signal constitué de créneaux C1, C2, C3, C4. Les émissions des signaux s'effectuent de manière synchrone.

Le tableau suivant regroupe la localisation de la coupure ou de la détérioration du câble en fonction des derniers symboles reçus respectivement par le récepteur B et le récepteur A. La connaissance du couple formé par les derniers symboles reçus de part et d'autre du câble à surveiller est nécessaire pour lever l'ambigüité temps/position qui resterait en cas de la seule connaissance de l'un des symboles : par exemple, la réception de S2 (voir tableau) comme dernier symbole par le récepteur de B pourrait correspondre à une coupure dans une autre partie du câble qu'entre le segment I et le segment II, mais qui serait produite à un instant différent de celui qui permet que, conjointement le dernier symbole reçu par le récepteur de A soir C4

| Localisation de la coupure | Dernier symbole reçu par récepteur B | Dernier symbole reçu par récepteur A |
|---|---|---|
| Entre segment I et segment II | S2 | C4 |
| Entre segment II et segment III | S3 | C3 |
| Entre segment III et segment IV | S4 | C2 |

Le système et le procédé selon l'invention offrent notamment les avantages suivants:

• Une instantanéité de la fourniture de la position de coupure,

• Une précision indépendante de la longueur du câble,

• Une indépendance de la méthode par rapport à la nature du câble surveillé,

• Une compatibilité avec la transmission d'autres signaux utiles dans le câble,

• Un dispositif utilisable pour la transmission d'information de service.

**Revendications**

1. Système pour détecter des détériorations ou des coupures C au niveau d'un câble (1) destiné à transmettre des signaux, entre au moins un premier dispositif A et au moins un deuxième dispositif B, ledit système comprenant le premier dispositif A et le deuxième dispositif B, et un moyen adapté à connaître la vitesse de propagation du signal dans ledit câble, **caractérisé en ce que**:

   • ledit premier dispositif A étant disposé à une première extrémité ($1_A$) du câble (1) et comprenant au moins un dispositif émetteur/récepteur (10e, 10r), des moyens de synchronisation (12), un moyen de communication (11) entre le premier dispositif A et le deuxième dispositif B, des moyens de calcul (13) de non réception du signal reliés au dispositif émetteur/récepteur (10e, 10r), le dispositif émetteur est adapté à émettre un signal $S_A$ de A vers B, le dispositif récepteur est adapté à mesurer des instants de non réception d'un signal,
   • ledit deuxième dispositif B étant disposé à une deuxième extrémité ($1_B$) du câble (1), ledit deuxième dispositif B comprenant au moins les éléments suivants un dispositif émetteur/récepteur (20e, 20r), des moyens de synchronisation (22) et d'émission simultanée du signal $S_A$ et du signal $S_B$ et des moyens de communication (21) entre A et B des moyens de calcul (23) de non réception d'un signal reliés au dispositif émetteur/récepteur (20e, 20r), le dispositif émetteur est adapté à émettre un signal $S_B$ de B vers A, le dispositif récepteur est adapté à mesurer des instants de non réception d'un signal,
   • les moyens de communication (11, 21) des mesures des instants de non réception des signaux effectuées au niveau des récepteurs (10e, 20e), sont adaptés à transférer les mesures de l'instant de non réception du signal $S_B$ au niveau du premier dispositif A et de l'instant de non réception du signal $S_A$ au niveau du deuxième dispositif B auxdits moyens de calcul de non réception d'un signal (13, 23), lesdits moyens de calcul étant adaptés à déterminer l'instant $t_C$ et la localisation $X_C$ du défaut ou de la coupure au niveau du câble (1) à partir des mesures de l'abscisse $X_A$ de A, de l'abscisse $X_B$ de B, de la vitesse de propagation V connue entre le point A et le point B, de l'instant $tr_B$ de disparition du signal mesuré par le récepteur B sur le signal $S_A$ et de l'instant $tr_A$ de disparition du signal mesuré par le récepteur A sur le signal $S_B$.

2. Système selon la revendication 1 **caractérisé en ce que** les moyens de calcul de non réception du signal sont adaptés à exécuter au moins les étapes suivantes:

   soit $X_A$ l'abscisse curviligne de A compté sur le câble (1), $X_B$ est l'abscisse curviligne de B considérée sur le câble, en considérant un sens croissant d'abscisse de B vers A,
   V étant la vitesse de propagation moyenne d'un signal dans le câble entre A et B, considérée constante ou sensiblement constante
   Soit $X_C$ l'abscisse curviligne du point de détérioration ou de coupure C du câble et $t_C$ l'instant de coupure
   soit $tr_B$ l'instant de disparition du signal mesuré par le récepteur B sur le signal $S_A$ et $tr_A$ l'instant de disparition du signal mesuré par le récepteur A sur le signal $S_B$
   ce qui donne la localisation $X_C$ de la coupure C au niveau du câble (1)

$$X_C = (X_A + X_B)/2 + V.(tr_B - tr_A)$$

   et l'instant de coupure $t_C$

$$t_C = (tr_A + tr_B)/2 + (X_B - X_A)/2V$$

3. Système selon la revendication 1 **caractérisé en ce que** les signaux $S_A$, $S_B$ émis par A et par B sont des signaux CDMA.

4. Système selon la revendication 1 **caractérisé en ce que** le câble (1) est un câble en cuivre.

5. Système selon la revendication 1 **caractérisé en ce que** le câble (1) est une fibre optique et les signaux émis pour détecter la détérioration ou la coupure des signaux optiques.

6. Système selon la revendication 1 **caractérisé en ce que** les moyens de communication entre le premier dispositif A et le deuxième dispositif B est composé d'un téléphone sans fil.

**7.** Système selon la revendication 1 **caractérisé en ce que** le moyen de synchronisation (12, 22) comporte un récepteur GPS.

**8.** Procédé permettant de détecter des détériorations ou des coupures C au niveau d'un câble (1) destiné à transmettre des signaux, le procédé étant mis en oeuvre dans le système selon la revendication 1, **caractérisé en ce qu'**il comporte au moins les étapes suivantes :

• Emettre simultanément au moins un premier signal $S_A$ d'un premier dispositif A vers un deuxième dispositif B et au moins un deuxième signal $S_B$ du deuxième dispositif B vers le premier dispositif A, l'émission se faisant de manière synchronisée,
• Détecter l'instant auquel il y a absence de réception du signal $S_A$ au niveau du récepteur de B et l'absence du signal $S_B$, au niveau du récepteur de A,
• Déterminer à partir de $tr_A$ l'instant de disparition du signal mesuré par le récepteur A, et de $tr_B$ l'instant de disparition du signal mesuré par le récepteur B, l'endroit $X_C$ et le moment $t_C$ de la coupure ou de la détérioration sur le câble.

**9.** Procédé selon la revendication 8 **caractérisé en ce que** la mesure de l'instant $tr_A$ de disparition du signal mesuré par le récepteur A, et de $tr_B$ l'instant de disparition du signal mesuré par le récepteur B, se fait en utilisant une valeur de niveau seuil S en dessous-duquel les signaux ne sont plus détectables.

**10.** Procédé selon la revendication 8 **caractérisé en ce qu'**il comporte au moins les étapes suivantes :

soit $X_A$ l'abscisse curviligne de A compté sur le câble (1), $X_B$ est l'abscisse curviligne de B considérée sur le câble, en considérant un sens croissant d'abscisse de B vers A,
V étant la vitesse de propagation moyenne d'un signal dans le câble entre A et B, considérée constante ou sensiblement constante
Soit $X_C$ l'abscisse curviligne du point de détérioration ou de coupure C du câble et $t_C$ l'instant de coupure
soit $tr_B$ l'instant de disparition du signal mesuré par le récepteur B sur le signal $S_A$ et $tr_A$ l'instant de disparition du signal mesuré par le récepteur A sur le signal $S_B$
ce qui donne la localisation $X_C$ de la coupure C au niveau du câble 1

$$X_C = (X_A + X_B)/2 + V.(tr_B - tr_A)$$

et l'instant de coupure $t_C$

$$t_C = (tr_A + tr_B)/2 + (X_B - X_A)/2V$$

**11.** Procédé selon la revendication 8 **caractérisé en ce que** l'on utilise des signaux CDMA et l'on détecte les derniers symboles reçus respectivement par au moins le premier dispositif A et au moins le deuxième dispositif B pour déterminer la zone de la coupure ou de la détérioration du câble.

**12.** Utilisation du système selon l'une des revendications 1 à 7 ou du procédé selon l'une des revendications 8 à 10 pour détecter des coupures ou des détériorations au niveau de câble en cuivre.

**Patentansprüche**

**1.** System zum Erkennen von Verschlechterungen oder Unterbrechungen C an einem Kabel (1) zum Übertragen von Signalen zwischen wenigstens einem ersten Gerät A und wenigstens einem zweiten Gerät B, wobei das System das erste Gerät A und das zweite Gerät B und ein Mittel umfasst, das zum Ermitteln der Ausbreitungsgeschwindigkeit des Signals in dem Kabel ausgelegt ist, **dadurch gekennzeichnet, dass**:

das erste Gerät A an einem ersten Ende ($1_A$) des Kabels (1) angeordnet ist und wenigstens ein Sende-/Empfangsgerät (10e, 10r), Synchronisationsmittel (12), ein Kommunikationsmittel (11) zwischen dem ersten Gerät A und dem zweiten Gerät B, Mittel (13) zum Berechnen des Nichtempfangs des Signals verbunden mit dem Sende-/Empfangsgerät (10e, 10r) umfasst, wobei das Sendegerät zum Senden eines Signals $S_A$ von A zu B ausgelegt ist, wobei das Empfangsgerät zum Messen der Nichtempfangszeitpunkte eines Signals ausgelegt ist, wobei das zweite Gerät B an einem zweiten Ende ($1_B$) des Kabels (1) angeordnet ist, wobei das zweite Gerät B wenigstens die folgenden Elemente umfasst: ein Sende-/Empfangsgerät (20e, 20r), Mittel (22) zum Synchronisieren und gleichzeitigen Senden des Signals $S_A$ und des Signals $S_B$ und Kommunikationsmittel (21) zwischen A und B, Mittel (23) zum Berechnen des Nichtempfangs eines Signals verbunden mit dem Sende-/Empfangsgerät (20e, 20r), wobei das Sendegerät zum Senden eines Signals $S_B$ von B zu A ausgelegt ist, wobei das Empfangsgerät zum Messen der Nichtempfangszeitpunkte eines Signals ausgelegt ist, wobei die Kommunikationsmittel (11, 21) für die an den Empfängern (10e, 20e) durchgeführten Messungen von Nichtempfangszeitpunkten der Signale zum Übertragen der Messwerte des Nichtempfangszeitpunkts des Signals $S_B$ am ersten Gerät A und des Nichtempfangszeitpunkts des Signals $S_A$ am zweiten Gerät B zu den Mitteln zum Berechnen des Nichtempfangs eines Signals (13, 23) ausgelegt sind, wobei die Rechenmittel zum Bestimmen des Zeitpunkts $t_C$ und des Orts $X_C$ der Störung oder Unterbrechung am Kabel (1) auf der Basis der Messungen der Abszisse $X_A$ von A, der Abszisse $X_B$ von B, der bekannten Ausbreitungsgeschwindigkeit V zwischen Punkt A und Punkt B, des Zeitpunkts $tr_B$ des Verschwindens des vom Empfänger B gemessenen Signals auf dem Signal $S_A$ und des Zeitpunkts $tr_A$ des Verschwindens des gemessenen Signals vom Empfänger A auf dem Signal $S_B$ ausgelegt sind.

2. System nach Anspruch 1, **dadurch gekennzeichnet, dass** die Mittel zum Berechnen des Nichtempfangs des Signals zum Ausführen wenigstens der folgenden Schritte ausgelegt sind:

$X_A$ sei die krummlinige Abszisse von A, gezählt auf dem Kabel (1), $X_B$ ist die krummlinige Abszisse von B auf dem Kabel betrachtet unter Berücksichtigung einer Anstiegsrichtung der Abszisse von B zu A, wobei V die mittlere Ausbreitungsgeschwindigkeit eines Signals in dem Kabel zwischen A und B unter konstanter oder im Wesentlichen konstanter Betrachtung ist, $X_C$ sei die krummlinige Abszisse des Punkts der Verschlechterung oder Unterbrechung C des Kabels und $t_C$ der Unterbrechungszeitpunkt, $tr_B$ sei der Zeitpunkt des Verschwindens des vom Empfänger B gemessenen Signals auf dem Signal $S_A$ und $tr_A$ der Zeitpunkt des Verschwindens des vom Empfänger A gemessenen Signals auf dem Signal $S_B$, was den Ort $X_C$ der Unterbrechung C am Kabel (1) ergibt:

$$X_C = (X_A + X_B)/2 + V.(tr_B - tr_A)$$

und den Zeitpunkt der Unterbrechung $t_C$

$$t_C = (tr_A + tr_B)/2 + (X_B - X_A)/2V$$

3. System nach Anspruch 1, **dadurch gekennzeichnet, dass** die von A und von B gesendeten Signale $S_A$, $S_B$ CDMA-Signale sind.

4. System nach Anspruch 1, **dadurch gekennzeichnet, dass** das Kabel (1) ein Kupferkabel ist.

5. System nach Anspruch 1, **dadurch gekennzeichnet, dass** das Kabel (1) ein Lichtwellenleiter ist und die Signale zum Erkennen der Verschlechterung oder Unterbrechung von optischen Signalen gesendet werden.

6. System nach Anspruch 1, **dadurch gekennzeichnet, dass** die Kommunikationsmittel zwischen dem ersten Gerät A und dem zweiten Gerät B von einem Mobiltelefon gebildet werden.

7. System nach Anspruch 1, **dadurch gekennzeichnet, dass** das Synchronisationsmittel (12, 22) einen GPS-Empfänger umfasst.

8. Verfahren zum Erkennen von Verschlechterungen oder Unterbrechungen C an einem Kabel (1) zum Übertragen von Signalen, wobei das Verfahren in dem System nach Anspruch 1 durchgeführt wird, **dadurch gekennzeichnet, dass** es wenigstens die folgenden Schritte beinhaltet:

gleichzeitiges Senden wenigstens eines ersten Signals $S_A$ eines ersten Geräts A zu einem zweiten Gerät B und wenigstens eines zweiten Signals $S_B$ des zweiten Geräts B zum ersten Gerät A, wobei das Senden auf synchronisierte Weise erfolgt,

Erkennen des Zeitpunkts, an dem das Signal $S_A$ am Empfänger von B nicht empfangen wird und das Signal $S_B$ am Empfänger von A nicht empfangen wird,

Bestimmen, auf der Basis von $tr_A$, des Zeitpunkts des Verschwindens des vom Empfänger A gemessenen Signals, und von $tr_B$, des Zeitpunkts des Verschwindens des vom Empfänger B gemessenen Signals, des Orts $X_C$ und des Moments $t_C$ der Unterbrechung und der Verschlechterung auf dem Kabel.

9. Verfahren nach Anspruch 8, **dadurch gekennzeichnet, dass** das Messen des Zeitpunkts $tr_A$ des Verschwindens des vom Empfänger A gemessenen Signals und von $tr_B$ des Zeitpunkts des Verschwindens des vom Empfänger B gemessenen Signals anhand eines Schwellenpegelwerts S erfolgt, unterhalb dessen die Signale nicht mehr erkennbar sind.

10. Verfahren nach Anspruch 8, **dadurch gekennzeichnet, dass** es wenigstens die folgenden Schritte beinhaltet:

$X_A$ sei die krummlinige Abszisse von A, gezählt auf dem Kabel (1), $X_B$ ist die krummlinige Abszisse von B, betrachtet auf dem Kabel, unter Berücksichtigung einer Anstiegsrichtung der Abszisse von B zu A,

wobei V die mittlere Ausbreitungsgeschwindigkeit eines Signals in dem Kabel zwischen A und B unter konstanter oder im Wesentlichen konstanter Betrachtung ist,

$X_C$ sei die krummlinige Abszisse des Punkts der Verschlechterung oder Unterbrechung C des Kabels und $t_C$ der Zeitpunkt der Unterbrechung,

$tr_B$ sei der Zeitpunkt des Verschwindens des vom Empfänger B gemessenen Signals auf dem Signal $S_A$ und $tr_A$ der Zeitpunkt des Verschwindens des vom Empfänger A gemessenen Signals auf dem Signal $S_B$,

was den Ort $X_C$ der Unterbrechung C am Kabel (1) ergibt:

$$X_C = (X_A + X_B)/2 + V.(tr_B - tr_A)$$

und den Zeitpunkt der Unterbrechung $t_C$

$$t_C = (tr_A + tr_B)/2 + (X_B - X_A)/2V.$$

11. Verfahren nach Anspruch 8, **dadurch gekennzeichnet, dass** CDMA-Signale verwendet werden und die letzten jeweils von wenigstens dem ersten Gerät A und wenigstens dem zweiten Gerät B empfangenen Symbole zum Bestimmen der Zone der Unterbrechung oder der Verschlechterung des Kabels benutzt werden.

12. Verwendung des Systems nach einem der Ansprüche 1 bis 7 oder des Verfahrens nach einem der Ansprüche 8 bis 10 zum Erkennen von Unterbrechungen oder Verschlechterungen an einem Kupferkabel.

**Claims**

1. A system for detecting deterioration of or cuts C in a cable (1) for transmitting signals between at least one first device A and at least one second device B, said system comprising the first device A and the second device B and a means adapted to know the propagation speed of the signal in said cable, **characterized in that**:

said first device A being disposed at a first end ($1_A$) of the cable (1) and comprising at least a transceiver (10e, 10r), synchronization means (12), means (11) for communication between the first device A and the second device B, calculation means (13) of non-reception of the signal connected to the transceiver (10e, 10r), the transmitter being adapted to transmit a signal $S_A$ from A to B, the receiver being adapted to measure times of non-reception of a signal,

said second device B being disposed at a second end ($1_B$) of the cable (1), said second device B including at least the following components: a transceiver (20e, 20r), means for synchronizing (22) and simultaneous transmission of the signal $S_A$ and the signal $S_B$ and means for communication (21) between A and B, calculation means (23) of non-reception of a signal connected to the transceiver (20e, 20r), ), the transmitter being adapted to transmit a signal $S_B$ from B to A, the receiver being adapted to measure times of non-reception of a signal, the means for communicating (11, 21) times of non-reception of the signals measured at the receivers (10e, 20e) are adapted to transfer the measured times of non-reception of the signal $S_B$ at the first device A and the measured time of non-reception of the signal $S_A$ at the second device B to said calculation means of non-reception of a signal (13, 23), said calculation means being adapted to determine the time $t_C$ and the location $X_C$ of the fault or the cut in the cable (1) from the measurements of abscissa $X_A$ of A, abscissa $X_B$ of B, the known speed of propagation V between point A and point B, the time $tr_B$ of disappearance of the signal measured by the receiver B of the signal $S_A$ and the time trA of disappearance of the signal measured by the receiver A of the Signal $S_B$.

2. The system according to claim 1, **characterized in that** the means for calculation of non-reception of the signal are adapted to execute at least the following steps:

   $X_A$ is the curvilinear abscissa of A as measured along the cable (1), $X_B$ is the curvilinear abscissa of B along the cable, considering a direction of increasing abscissa from B to A,
   V is the average speed of propagation of a signal in the cable between A and B, considered constant or substantially constant,
   $X_C$ is the curvilinear abscissa of the point of deterioration or the cut C in the cable and $t_C$ is the cut time,
   $tr_B$ is the time of non-reception of the signal measured by the receiver B on the signal $S_A$ and $tr_A$ is the time of the disappearance of the signal measured by the receiver A on the signal $S_B$
   which gives the location $X_C$ of the cut C in the cable (1)

$$X_C = (X_A+X_B)/2+V.(tr_B-tr_A)$$

   and the cut time $t_C$

$$t_C = (tr_A+tr_B)/2+(X_B-X_A)/2V$$

3. The system according to claim 1, **characterized in that** the signals $S_A$, $S_B$ transmitted by A and B are CDMA signals.

4. The system according to claim 1, **characterized in that** the cable (1) is a copper cable.

5. The system according to claim 1, **characterized in that** the cable (1) is an optical fiber and the signals transmitted to detect deterioration or cutting are optical signals.

6. The system according to claim 1, **characterized in that** the means for communication between the first device A and the second device B consist of a wireless telephone.

7. The system according to claim 1, **characterized in that** the synchronization means (12, 22) includes a GPS receiver.

8. A method for detecting deterioration of or cuts C in a cable (1) for transmitting signals, the method being employed in the system according to claim 1, **characterized in that** it comprises at least the following steps:

   transmitting simultaneously at least one first signal $S_A$ from a first device A to a second device B and at least one second signal $S_B$ from the second device B to the first device A, the transmission being synchronized,
   detecting the time at which there is absence of reception of the signal $S_A$ at the receiver of B and absence of the signal $S_B$ at the receiver of A,
   determining from $tr_A$ the time of disappearance of the signal measured by the receiver A and from $tr_B$ the time of disappearance of the signal measured by the receiver B, the location $X_C$ and the time $t_C$ of the cut in or the deterioration of the cable.

9. The method according to claim 8, **characterized in that** the measurement of the time $tr_A$ of disappearance of the signal measured by the receiver A and the time $tr_B$ of disappearance of the signal measured by the receiver B are measured using a threshold level value S below which the signals are no longer detectable.

**10.** The method according to claim 8, **characterized in that** it comprises at least the following steps:

$X_A$ is the curvilinear abscissa of A as measured along the cable (1), $X_B$ is the curvilinear abscissa of B along the cable, considering a direction of increasing abscissa from B to A,

V is the average speed of propagation of a signal in the cable between A and B, considered constant or substantially constant,

$X_C$ is the curvilinear abscissa of the point of deterioration or the cut C in the cable and $t_C$ is the cut time,

$tr_B$ is the time of disappearance of the signal measured by the receiver of B on the signal $S_A$ and $tr_A$ is the time of disappearance of the signal measured by the receiver A on the signal $S_B$

which gives the location $X_C$ of the cut C in the cable 1:

$$X_C = (X_A + X_B)/2 + V.(tr_B - tr_A)$$

and the cut time $t_C$:

$$t_C = (tr_A + tr_B)/2 + (X_B - X_A)/2V.$$

**11.** The method according to claim 8, **characterized in that** CDMA signals are used and the last symbols respectively received by at least the first device A and at least the second device B are detected to determine the area of the cut in or the deterioration of the cable.

**12.** The use of the system according to any one of claims 1 to 7 or the method according to any one of claims 8 to 10 to detect cuts in or deterioration of copper cable.

FIG.1

FIG.2

EP 2 691 785 B1

FIG.3

| Localisation de la coupure | Dernier symbole reçu par récepteur B | Dernier symbole reçu par récepteur A |
|---|---|---|
| Entre segment I et segment II | S2 | C4 |
| Entre segment II et segment III | S3 | C3 |
| Entre segment III et segment IV | S4 | C2 |

FIG.4

EP 2 691 785 B1

**RÉFÉRENCES CITÉES DANS LA DESCRIPTION**

**Documents brevets cités dans la description**

- US 2006012374 A
- US 2004039976 A